(19) Europäisches Patentamt
European Patent Office
Office européen des brevets

(11) **EP 3 080 623 B1**

(12) # EUROPEAN PATENT SPECIFICATION

(45) Date of publication and mention
of the grant of the patent:
**15.07.2020 Bulletin 2020/29**

(51) Int Cl.:
***G01R 31/34*** *(2020.01)*  ***H02K 19/36*** *(2006.01)*
***H02P 21/14*** *(2016.01)*

(21) Application number: **14830645.9**

(22) Date of filing: **12.12.2014**

(86) International application number:
**PCT/IB2014/066861**

(87) International publication number:
**WO 2015/087301 (18.06.2015 Gazette 2015/24)**

(54) **APPARATUS AND METHOD FOR PERFORMING INSTANTANEOUS SHORT-CIRCUIT TESTS ON POLYPHASE SYNCHRONOUS GENERATOR**

VORRICHTUNG UND VERFAHREN ZUR AUSFÜHRUNG VON UNVERZÖGERTEN KURZSCHLUSSTESTS BEI EINEM MEHRPHASIGEN SYNCHRONGENERATOR

APPAREIL ET PROCÉDÉ PERMETTANT DE METTRE EN OEUVRE DES TESTS INSTANTANÉS DE COURT-CIRCUIT SUR UN GÉNÉRATEUR SYNCHRONE POLYPHASÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **12.12.2013 IT MI20132077**

(43) Date of publication of application:
**19.10.2016 Bulletin 2016/42**

(73) Proprietor: **Ansaldo Energia S.p.A.**
**16152 Genova (IT)**

(72) Inventors:
• **CRESTA, Gabriele**
**I-16156 Genova (IT)**
• **BERGAGLIO, Massimo**
**I-16014 Ceranesi (IT)**
• **VALGIMIGLI, Marco**
**I-16149 Genova (IT)**

(74) Representative: **Bernotti, Andrea et al**
**Studio Torta S.p.A.**
**Via Viotti, 9**
**10121 Torino (IT)**

(56) References cited:
• **HIROYUKI HATTA ET AL: "Experimental Study on Sudden-short-circuit Characteristic of Synchronous Generator with SCFCL", IEEE TRANSACTIONS ON APPLIED SUPERCONDUCTIVITY, IEEE SERVICE CENTER, LOS ALAMITOS, CA, US, vol. 11, no. 1, 1 March 2001 (2001-03-01), pages 2343-2346, XP011090815, ISSN: 1051-8223**
• **Laura L Juárez-Caltzontzin ET AL: "Theoretical and Experimental Analysis of the Short Circuit Current Components in Salient Pole Synchronous Generators", Proceedings of the 11th Spanish Portuguese Conference on Electrical Engineering (11CHLIE), 4 July 2009 (2009-07-04), pages 1-8, XP055135588, Zaragoza, SPAIN Retrieved from the Internet: URL:http://www.aedie.org/11chlie-papers/24 9-Juarez.pdf [retrieved on 2014-08-20]**
• **Abdolreza Esmaeli: "A New Test Set to Synchronous Generator Sudden Three-phase Short-circuit Based on Power Electronic Technique and Microcontroller Technique", Journal of Basic and Applied Scientific Research, 1 January 2012 (2012-01-01), pages 8101-8105, XP055135548, Retrieved from the Internet: URL:http://www.textroad.com/pdf/JBASR/J. Basic. Appl. Sci. Res., 2(8)8101-8105, 2012.pdf [retrieved on 2014-08-20]**

EP 3 080 623 B1

- **BAILEY W O S ET AL: "Short Circuit Tests on a Coreless HTS Synchronous Generator", IEEE TRANSACTIONS ON APPLIED SUPERCONDUCTIVITY, IEEE SERVICE CENTER, LOS ALAMITOS, CA, US, vol. 23, no. 3, 1 June 2013 (2013-06-01), page 5201505, XP011513695, ISSN: 1051-8223, DOI: 10.1109/TASC.2013.2244196**

- **CISNEROS-GONZA LEZ M ET AL: "Parameter Estimation of a Synchronous-Generator Two-Axis Model Based on the Standstill Chirp Test", IEEE TRANSACTIONS ON ENERGY CONVERSION, IEEE SERVICE CENTER, PISCATAWAY, NJ, US, vol. 28, no. 1, 1 March 2013 (2013-03-01), pages 44-51, XP011515968, ISSN: 0885-8969, DOI: 10.1109/TEC.2012.2236433**

## Description

TECHNICAL FIELD

The present invention relates to an apparatus and method for performing instantaneous short-circuit tests on polyphase synchronous generators.

BACKGROUND ART

As is known, the so-called "instantaneous short-circuit" test is a measurement method which allows to determine some characteristic parameters of polyphase (in particular, three-phase) synchronous generators, and is unanimously recognized as highly reliable. The method is encoded by international standards (IEC60034 and IEEE115) and allows to determine the following circuit parameters:

Xd' = direct axis transient reactance
Xd" = direct axis sub-transient reactance
Td' = direct axis transient time constant
Td" = direct axis sub-transient time constant
Ta = direct axis armature time constant

These parameters, obtained experimentally, are essential to verify the correct modeling of a synchronous generator and to refine the calculation codes used at the design stage.

The three-phase instantaneous short-circuit test requires the rotor to be set to nominal rotation speed in the presence of an excitation current, so that a triad of symmetrical three-phase voltages is present at the terminals of the generator. When the test conditions are achieved, an instantaneous short-circuit is caused between the terminals of the generator by closing a dedicated switch. During the transient following the switch closure, the stator short-circuit currents, the rotor excitation current and the temperature of the rotor and stator windings are measured.

In order to obtain the short circuit, a medium voltage switch is generally used, which is dimensioned so as to withstand the strong currents and the electrodynamic stresses during the transient. The switch has first terminals rigidly connected to respective stator terminals of the generator and second terminals connected to one another in short-circuit through respective low inductive component shunts, which allow the transient of the short-circuit stator currents to be measured. The circuit parameters searched can be extrapolated from the short-circuit stator currents.

The generator must be brought to the nominal rotation speed by a prime mover. However, the prime mover cannot be powered during the short-circuit, in order to avoid torsional moments which could easily damage both the mover and the generator. A descending speed transient is thus carried out. In practice, the prime mover takes the rotor to a rotation speed higher than the nominal speed, then the mover power supply is removed and the rotor is allowed to slow down by inertia.

The short-circuit is carried out at the rotation speed as close as possible to the nominal speed.

The operation of closing the switch to perform the short-circuit is currently performed manually and is therefore rather inaccurate. In particular, the rotation speed when closing the switch is only approximately near the nominal rotation speed and there is no control over the sinusoidal voltages of the generator.

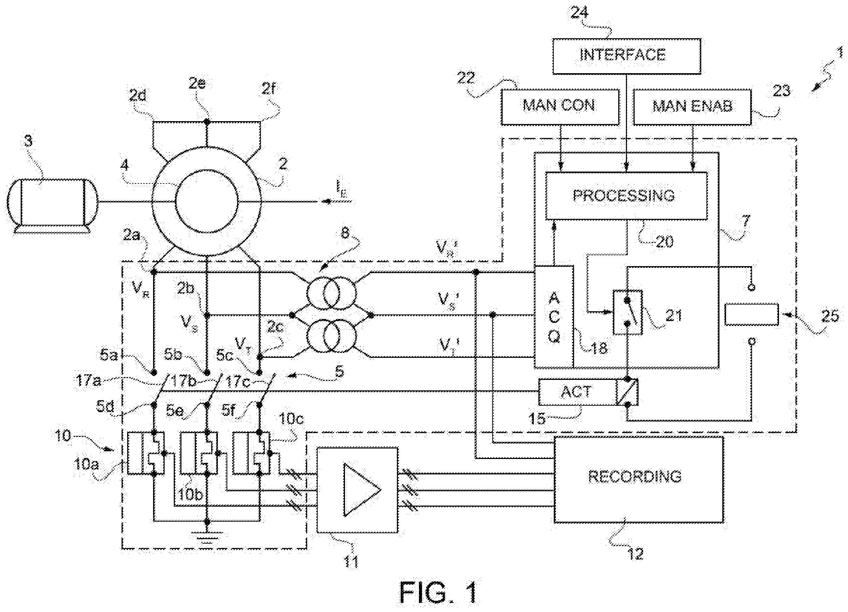

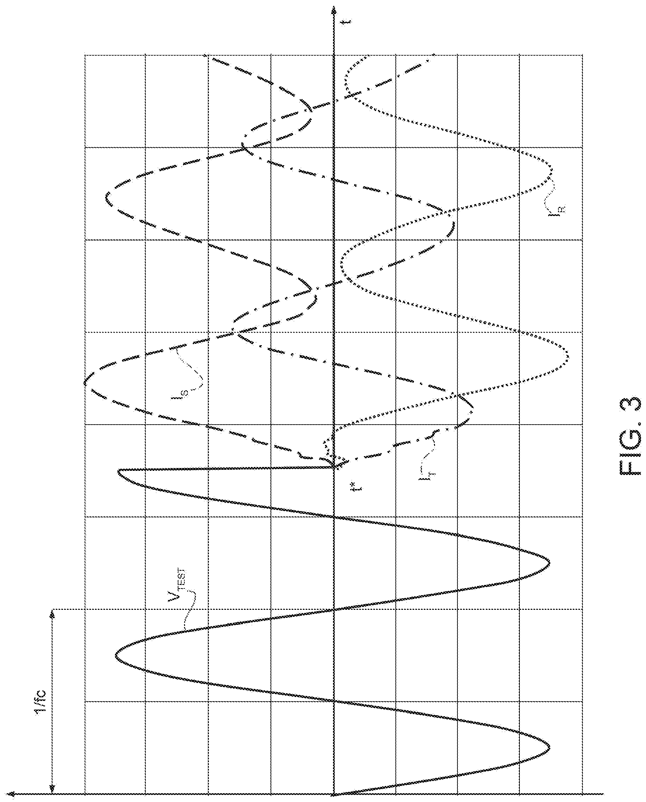

Examples of known apparatus and method in accordance with the preambles of independent claims 1 and 6, respectively, are disclosed in HIROYUKI HATTA ET AL, "Experimental Study on Sudden-short-circuit Characteristic of Synchronous Generator with SCFCL", IEEE TRANSACTIONS ON APPLIED SUPERCONDUCTIVITY, IEEE SERVICE CENTER, LOS ALAMITOS, CA, US, (20010301), vol. 11, no. 1, ISSN 1051-8223, pages 2343 - 2346, page 2344, column r, paragraph 2 - page 2346, column r, paragraph l; figures 3-10; table III [A] 4,13 [Y] 9-12,14,15 [I] 5-8. Other examples of known apparatus and method are disclosed in Laura L Juárez-Caltzontzin ET AL, "Theoretical and Experimental Analysis of the Short Circuit Current Components in Salient Pole Synchronous Generators", Proceedings of the 11th Spanish Portuguese Conference on Electrical Engineering (11CHLIE), Zaragoza, SPAIN, (20090704), pages 1 - 8, URL: http://www.aedie.org/llchlie-papers/249-Juarez.pdf, (20140820), page 3, column 1, paragraph 1 - page 8, column r, paragraph 2; figures 5-28, in Abdolreza Esmaeli, "A New Test Set to Synchronous Generator Sudden Three-phase Short-circuit Based on Power Electronic Technique and Microcontroller Technique", Journal of Basic and Applied Scientific Research, (20120101), pages 8101 - 8105, URL: http://www.textroad.com/pdf/JBASR/J. Basic. Appl. Sci. Res., 2(8)8101-8105, 2012.pdf, (20140820), page 8101, paragraph 1 - page 8102, paragraph 4; figures 1,2,3 page 8014, in BAILEY W O S ET AL, "Short Circuit Tests on a Coreless HTS Synchronous Generator", IEEE TRANSACTIONS ON APPLIED SUPERCONDUCTIVITY, IEEE SERVICE CENTER, LOS ALAMITOS, CA, US, (20130601), vol. 23, no. 3, doi:10.1109/TASC.2013.2244196, ISSN 1051-8223, page 5201505, abstract, page 2, column 1, paragraph 3 - page 4, column r, paragraph 1 [A] 1 DOI: http://dx.doi.org/10.1109/TASC.2013.2244196 and in CISNEROS-GONZA LEZ M ET AL, "Parameter Estimation of a Synchronous-Generator Two-Axis Model Based on the Standstill Chirp Test", IEEE TRANSACTIONS ON ENERGY CONVERSION, IEEE SERVICE CENTER, PISCATAWAY, NJ, US, (20130301), vol. 28, no. 1, doi:10.1109/TEC.2012.2236433, ISSN 0885-8969, pages 44 - 51, page 48, column r, paragraph 1 - page 50, column r, paragraph 2; figures 10-14.

## DISCLOSURE OF INVENTION

Therefore, it is an object of the present invention to provide an apparatus and method for performing instantaneous short-circuit tests on polyphase synchronous generators which allow to overcome or at least mitigate the limitations described.

According to the present invention, an apparatus and a method for performing instantaneous short-circuit tests on polyphase synchronous generators are provided as defined in claims 1 and 6, respectively.

## BRIEF DESCRIPTION OF THE DRAWINGS

The present invention will now be described with reference to the accompanying drawings, which show a nonlimiting example thereof, in which:

- figure 1 is a simplified block diagram of an apparatus for performing instantaneous short-circuit tests on rotors of polyphase synchronous generators in accordance with an embodiment of the present invention;
- figure 2 is a flow diagram relating to a method of performing three-phase instantaneous short-circuit tests on rotors of polyphase synchronous generator in accordance with an embodiment of the present invention; and
- figure 3 is a graph showing quantities used in the apparatus in figure 1.

## BEST MODE FOR CARRYING OUT THE INVENTION

For simplicity, the invention will be hereinafter described with reference to the case of a three-phase electric generator. However, this should not be considered as limiting since the invention can be advantageously applied to electric generators with any number of phases.

With reference to figure 1, an apparatus for performing three-phase instantaneous short-circuit tests on rotors of polyphase synchronous generators is indicated as a whole with reference numeral 1. Apparatus 1 is connected to an electric generator 2, in particular a three-phase synchronous generator, the rotor 4 of which is mechanically coupled to a prime mover 3. The electric generator 2 has three stator terminals 2a, 2b, 2c connected to a switch 5 and three stator terminals 2d, 2e, 2f connected to one another and forming the star center of the electric generator 2.

Apparatus 1 comprises the switch 5, a control unit 7, a voltage measurement stage 8, a current measurement stage 10, an amplifier 11 and a recording device 12.

Switch 5 is a normally open, electromechanical medium voltage switch and includes first terminals 5a, 5b, 5c, second terminals 5d, 5e, 5f, and an actuator 15 which may be operated by the control unit 7.

The first terminals 5a, 5b, 5c are connected to respective stator terminals 2a, 2b, 2c of the electric generator 2. The connection may advantageously be carried out in a rigid manner, for example by copper bars (not shown). The second terminals 5d, 5e, 5f are connected to one another through the current measurement stage 10. More in detail, the current measurement stage 10 comprises three shunts 10a, 10b, 10c, having first conduction terminals connected to respective second terminals 5d, 5e, 5f of switch 5 and second conduction terminals shorted-circuited and connected to a common reference line 16, such as a land line. In practice, the current measurement stage 10 comprises a respective shunt for each phase of the electric generator 2. Measurement terminals of shunts 10a, 10b, 10c are connected to respective inputs of amplifier 11, the outputs of which are connected to the recording device 12.

Actuator 15 is controlled by the control unit 7 as shown hereafter to selectively open and close electric contacts between pairs of first terminals 5a, 5b, 5c and second terminals 5d, 5e, 5f by respective closing members 17a, 17b, 17c.

The control unit comprises an acquisition module 18, a processing module 20 and a control module 21.

The acquisition module 18 is coupled to the stator terminals 2a, 2b, 2c of the electric generator 2 through transformer 8 in order to receive electric signals $V_R'$, $V_S'$, $V_T'$ representative of output voltages $V_R$, $V_S$, $V_T$ present on the stator terminals 2a, 2b, 2c, respectively.

The values of the output voltages $V_R$, $V_S$, $V_T$ acquired are supplied to the processing module 20 and used to monitor the test conditions and perform the short-circuit of the stator terminals 2a, 2b, 2c.

In particular, the processing module 20 is configured to determine the rotation speed of the electric generator 2 from a monitoring voltage, for example the linked voltage $V_R$-$V_S$ and, when the current rotation speed is equal to a reference speed (for example, the nominal rotation speed of the rotor 4 of the electric generator 2), to cause switch 5 to close in a synchronized manner with the monitoring voltage or one of the output voltages $V_R$, $V_S$, $V_T$.

The processing module 20 is further provided with an input for receiving a start test control from a manual control device 22 and an enable control from a manual enable device 23. For example, the manual control device 22 and the manual enable device 23 may include each a button operated by an operator or more buttons to be operated simultaneously, for safety reasons. A configuration interface 24 is connected to further inputs of the processing module 20 and allows test parameters (e.g. type of switch 5, nominal rate of the electric generator 2) to be set.

The closing and opening of switch 5 are obtained through a control signal $S_C$ supplied by the processing module 20 to the control device 21, which in turn acts on actuator 15. In one embodiment, the control device 21 is a relay which closes in response to the control signal $S_C$, thus connecting the terminals of actuator 15 to a power source 25. When actuator 15 is powered, the closing members 17a, 17b, 17c close the electric contacts between the first terminals 5a, 5b, 5c and the second terminals 5d, 5e, 5f causing the short-circuit of the stator terminals 2a, 2b, 2c of the electric generator 2; when the control device 21 removes the power from the terminals of actuator 15, switch 5 opens and the short-circuit between the stator terminals 2a, 2b, 2c of the electric generator 2 is interrupted.

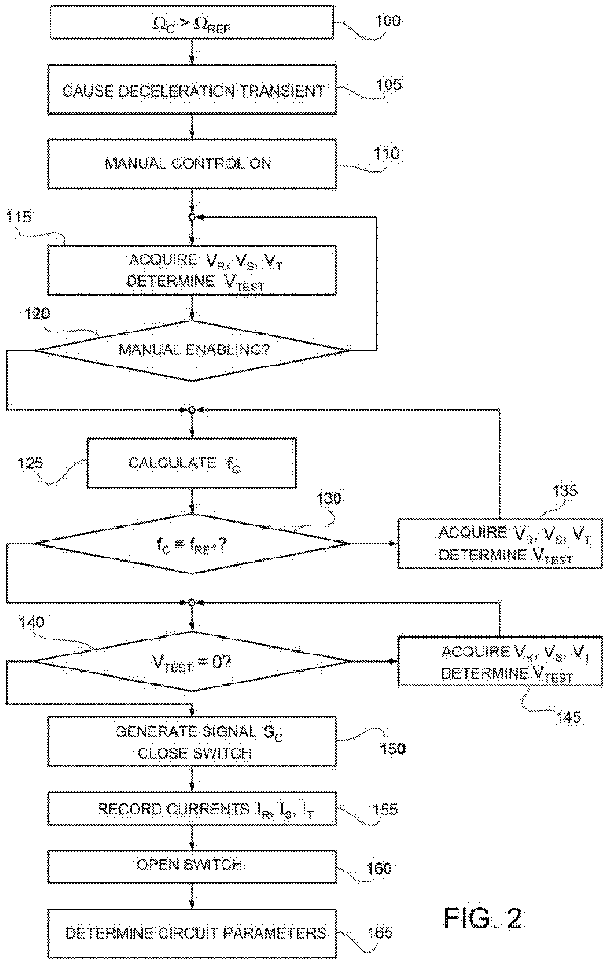

Apparatus 1 operates as described below with reference to figure 2.

The electric generator 2 is preliminarily brought to a current rotation speed $\Omega_C$ greater than the reference rotation speed $\Omega_{REF}$ by the prime mover 3 (block 100). The prime mover 3 is then stopped and the three-phase instantaneous short-circuit test procedure is performed during the deceleration transient of the rotor 4 of the electric generator 2 (block 105). In this step, the rotor 4 of the electric generator 2 receives excitation currents $I_e$.

The test procedure begins with the activation of the manual control device 22 by an operator (block 110).

The control module 20 starts receiving the values of the output voltages $V_R$, $V_S$, $V_T$ acquired by the acquisition module 18 and determines a test voltage $V_{TEST}$, such as the linked voltage $V_R$-$V_S$ (block 115).

Until the manual enable device 23 remains inactive (block 120, NO), the processing module 20 continues to acquire values of the test voltage $V_{TEST}$ and waits.

When the manual enable device 23 is activated to provide the enable command (block 120, YES), the processing module 20 calculates the current oscillation frequency $f_C$ of the test voltage $V_{TEST}$ (block 125) and compares it with a reference frequency $f_{REF}$, e.g. 50 Hz or 60 Hz (block 130). Thereby, in practice, the processing module 20 checks whether the current rotation speed $\Omega_C$ of rotor 4 of the electric generator 2 corresponds to the reference speed $\Omega_{REF}$.

Until the current frequency $f_C$ of the test voltage $V_{TEST}$ remains higher than the reference frequency $f_{REF}$ (block 130, NO), the processing unit continues to acquire new values of the test voltage $V_{TEST}$ (block 135) and updates the value of its current frequency $f_C$ (block 125).

When the current frequency $f_C$ equals frequency $f_{REF}$ (block 130, YES), the processing module 20 checks whether the test voltage $V_{TEST}$ is null (block 140) and continues to acquire new values of the test voltage $V_{TEST}$ (block 140, NO; block 145) until the first zero crossing of the test voltage $V_{TEST}$ is detected (block 140, YES).

At this point (block 150), the processing module 20 generates the control signal $S_C$ synchronized so that the closure of switch 5 coincides with the first (positive or negative) peak of the test voltage $V_{TEST}$, as shown in figure 3. In practice, the control signal SC is generated with an advance $\tau$ compared to the first peak of the test voltage $V_{TEST}$. The advance $\tau$ takes into account the delay of the control chain (i.e. the response time of the processing module 20, the implementation time of the control device 21 and the closure time of switch 5) and may be determined experimentally. Instant t* in which the control for closing switch 5 must be given through the control signal $S_C$ may be calculated as

$$t^* = t_0 + \frac{1}{4f_C} - \tau$$

where $t_0$ is the first instant in which the test voltage $V_{TEST}$ is null after the processing module 20 has recognized condition $f_C = f_{REF}$. Note that the first peak of the test voltage $V_{TEST}$ can be either positive or negative.

Switch 5 is then accurately closed when the current rotation speed $\Omega_C$ of the rotor 4 of the electric generator 2 is equal to the reference rotation speed $\Omega_{REF}$ and one of the output voltages $V_R$, $V_S$, $V_T$ has a positive or negative peak.

Meanwhile, the recording device 12 records the transient short-circuit currents $I_R$, $I_S$, $I_T$ which may be measured by shunts 10a, 10b, 10c (block 155).

The control signal $S_C$ has a duration $\Delta t$, after which switch 5 is opened to remove the short-circuit condition (block 160).

The data collected by the recording device 12 are then processed to determine the circuit parameters of the electric generator 2 (block 165).

The device described advantageously allows to perform sudden short-circuit tests under optimal and repeatable conditions, both as regards the rotation speed and the synchronization of the switch closure with the test voltage. The inherent variability when manually performing the short-circuit is thus overcome and therefore, the measurement of the circuit parameters appears overall more accurate and reliable.

Finally, it is apparent that changes and variations may be made to the device and method described without departing from the scope of the present invention, as defined in the appended claims.

As already mentioned above, in particular, the invention may be advantageously applied to electric generators with any number of phases, for example, but not exclusively, four or five. In these cases, the switch has as many first terminals and second terminals as the phases of the electric generator. Each first terminal is connected to a respective stator terminal of the electric generator. The stator terminals not used by the switch (i.e. half of the total) are connected to one another to form the star center of the polyphase electric generator.

Likewise, the current measurement module comprises a respective shunt for each phase of the electric generator. The shunts have first conduction terminals connected to respective second terminals of the switch and second conduction terminals short-circuited. The measurement terminals of the shunts are connected to respective inputs of the amplifier for recording.

Thereby, the closure of the switch causes a short-circuit between the stator terminals of the electric generator, and the transient currents generated are measured accordingly through the current measurement module, exactly as in the case of the three-phase electric generator described above in detail.

## Claims

1. An apparatus for performing an instantaneous short-circuit test on a polyphase synchronous generator, comprising:

   a switch (5) having first terminals (5a, 5b, 5c) for connection to respective stator terminals (2a, 2b, 2c) of an electric generator (2) and second terminals (5d, 5e, 5f) connected to one another;
   an acquisition module (18) configured to acquire electric signals ($V_R$', $V_S$', $V_T$') representative of output voltages ($V_R$, $V_S$, $V_T$) at respective stator terminals (2a, 2b, 2c) of the electric generator (2); and
   a processing module (20) configured to determine a test voltage ($V_{TEST}$) from the output voltages ($V_R$, $V_S$, $V_T$) of the electric generator (2); **characterized in that** the processing module (20) is configured to determine a current frequency ($f_c$) of the test voltage ($V_{TEST}$), and to compare the current frequency ($f_c$) with a reference frequency ($f_{REF}$), wherein the processing module (20) is further configured to keep the switch (5) open when the current frequency ($f_c$) is greater than the reference frequency ($f_{REF}$), and to close the switch (5) when the current frequency ($f_c$) substantially equals the reference frequency ($f_{REF}$).

2. The apparatus according to any one of Claim 1, wherein the processing module (20) is configured to determine zero crossovers of the test voltage ($V_{TEST}$), and to synchronize closure Of the switch (5) with a test voltage ($V_{TEST}$) peak.

3. The apparatus according to any one of the foregoing Claims, comprising a control device (21), acting on an actuator (15) of the switch (5) to close the switch (5) in response to a control signal ($S_c$) generated by the processing module (20).

4. The apparatus according to any one of the foregoing Claims, comprising a current measuring stage (10) coupled to the second terminals (5d, 5e, 5f) of the switch (5) and configured to measure transient short-circuit currents generated at the stator terminals (2a, 2b, 2c) of the electric generator (2) in response to closure of the switch (5) .

5. The apparatus according to any one of the foregoing Claims, comprising an electric generator (2) and a prime mover (3) connected to the electric generator (2) to rotate a rotor (4) of the electric generator (2).

6. A method of performing an instantaneous short-circuit test on a polyphase synchronous generator, the method comprising:

   setting a rotor (4) of an electric generator (2) to a current rotation speed ($\Omega_C$) greater than a reference rotation speed ($\Omega_{REF}$);
   supplying excitation currents ($I_E$) to the rotor (4) of the electric generator (2) during a deceleration transient;
   acquiring electric signals ($V_R$', $V_S$', $V_T$') representative of output voltages ($V_R$, Vs, $V_T$) at respective stator terminals (2a, 2b, 2c) of the electric generator (2) ;
   determining a test voltage ($V_{TEST}$) from the output voltages ($V_R$, $V_S$, $V_T$) of the electric generator (2);
   causing a short-circuit between the stator terminals (2a, 2b, 2c) of the electric generator (2), wherein causing a short-circuit comprises closing a switch (5) having first terminals (5a, 5b, 5c) connected to respective stator terminals (2a, 2b, 2c) of the electric generator (2), and second terminals (5d, 5e, 5f) connected to one another; **characterized by**:

   determining a current frequency ($f_c$) of the test voltage ($V_{TEST}$), and comparing the current frequency ($f_c$) with a reference frequency ($f_{REF}$); and
   causing the short-circuit when the current frequency ($f_c$) substantially equals the reference frequency ($f_{REF}$).

7. The method according to Claim 6, comprising determining zero crossovers of the test voltage ($V_{TEST}$), and synchronizing closure Of the switch (5) with a test voltage ($V_{TEST}$) peak.

8. The method according to any one of Claims 6 or 7, comprising measuring transient short-circuit currents generated at the stator terminals (2a, 2b, 2c) of the electric generator (2) in response to the short-circuit between the stator terminals (2a, 2b, 2c).

## Patentansprüche

1. Vorrichtung zur Durchführung einer verzögerungsfreien Kurzschlussprüfung an einem Mehrphasen-Synchrongenerator, enthaltend:

   einen Schalter (5), der erste Anschlüsse (5a, 5b, 5c) zum Anschluss an jeweilige Statoranschlüsse (2a, 2b, 2c) eines elektrischen Generators (2) und zweite Anschlüsse (5d, 5e, 5f) aufweist, die miteinander verbunden sind;

ein Erfassungsmodul (18), das dafür konfiguriert ist, elektrische Signale ($V_R$', $V_S$', $V_T$') zu erfassen, die Ausgangsspannungen ($V_R$, $V_S$, $V_T$) an jeweiligen Statoranschlüssen (2a, 2b, 2c) des elektrischen Generators (2) darstellen;

ein Verarbeitungsmodul (20), das dafür konfiguriert ist, eine Prüfspannung ($V_{TEST}$) aus den Ausgangsspannungen ($V_R$, $V_S$, $V_T$) des elektrischen Generators (2) zu ermitteln;

**dadurch gekennzeichnet, dass** das Verarbeitungsmodul (20) dafür konfiguriert ist, eine Stromfrequenz ($f_c$) der Prüfspannung ($V_{TEST}$) zu ermitteln und die Stromfrequenz ($f_c$) mit einer Referenzfrequenz ($f_{REF}$) zu vergleichen, wobei das Verarbeitungsmodul (20) ferner dafür konfiguriert ist, den Schalter (5) offen zu halten, wenn die Stromfrequenz ($f_c$) größer ist als die Referenzfrequenz ($f_{REF}$), und den Schalter (5) zu schließen, wenn die Stromfrequenz ($f_c$) im Wesentlichen gleich der Referenzfrequenz ($f_{REF}$) ist.

2. Vorrichtung nach einem von Anspruch 1, wobei das Verarbeitungsmodul (20) dafür konfiguriert ist, Nulldurchgänge der Prüfspannung ($V_{TEST}$) zu ermitteln und das Schließen des Schalters (5) mit einem Spitzenwert der Prüfspannung ($V_{TEST}$) zu synchronisieren.

3. Vorrichtung nach einem der vorstehenden Ansprüche, enthaltend eine Steuereinrichtung (21), die auf einen Aktuator (15) des Schalters (5) einwirkt, um den Schalter (5) ansprechend auf ein von dem Verarbeitungsmodul (20) erzeugtes Steuersignal ($S_c$) zu schließen.

4. Vorrichtung nach einem der vorstehenden Ansprüche, enthaltend eine Strommeßstufe (10), die mit den zweiten Anschlüssen (5d, 5e, 5f) des Schalters (5) gekoppelt ist und dafür konfiguriert ist, transiente Kurzschlussströme zu messen, die an den Statoranschlüssen (2a, 2b, 2c) des elektrischen Generators (2) ansprechend auf das Schließen des Schalters (5) erzeugt werden.

5. Vorrichtung nach einem der vorstehenden Ansprüche, enthaltend einen elektrischen Generator (2) und eine mit dem elektrischen Generator (2) verbundene Antriebseinrichtung (3), um einen Rotor (4) des elektrischen Generators (2) zu drehen.

6. Verfahren zur Durchführung einer verzögerungsfreien Kurzschlussprüfung an einem Mehrphasen-Synchrongenerator, welches Verfahren enthält:

Einstellen eines Rotors (4) eines elektrischen Generators (2) auf eine aktuelle Drehzahl ($\Omega_C$), die größer ist als eine Referenzdrehzahl ($\Omega_{REF}$);

Anlegen eines Erregerstroms ($I_E$) an den Rotor (4) des elektrischen Generators (2) während eines Verzögerungsübergangs;

Erfassen von elektrischen Signalen ($V_R$', $V_S$', $V_T$'), die Ausgangsspannungen ($V_R$, $V_S$, $V_T$) an jeweiligen Statoranschlüssen (2a, 2b, 2c) des elektrischen Generators (2) darstellen;

Ermitteln einer Prüfspannung ($V_{TEST}$) aus den Ausgangsspannungen ($V_R$, $V_S$, $V_T$) des elektrischen Generators (2);

Verursachen eines Kurzschlusses zwischen den Statoranschlüssen (2a, 2b, 2c) des elektrischen Generators (2), wobei das Verursachen eines Kurzschlusses das Schließen eines Schalters (5) umfasst, der erste Anschlüsse (5a, 5b, 5c) hat, die mit den jeweiligen Statoranschlüssen (2a, 2b, 2c) des elektrischen Generators (2) verbunden sind, und zweite Anschlüsse (5d, 5e, 5f), die miteinander verbunden sind;

**gekennzeichnet durch**:

Ermitteln einer Stromfrequenz ($f_c$) der Prüfspannung ($V_{TEST}$) und Vergleichen der Stromfrequenz ($f_c$) mit einer Referenzfrequenz ($f_{REF}$) ; und

Verursachen des Kurzschlusses, wenn die Stromfrequenz ($f_c$) im Wesentlichen gleich der Referenzfrequenz ($f_{REF}$) ist.

7. Verfahren nach Anspruch 6, enthaltend das Ermitteln von Nulldurchgängen der Prüfspannung ($V_{TEST}$) und das Synchronisieren des Schließens des Schalters (5) mit einem Spitzenwert der Prüfspannung ($V_{TEST}$).

8. Verfahren nach einem der Ansprüche 6 oder 7, enthaltend das Messen von transienten Kurzschlussströmen, die an den Statoranschlüssen (2a, 2b, 2c) des elektrischen Generators (2) ansprechend auf den Kurzschluss zwischen den Statoranschlüssen (2a, 2b, 2c) erzeugt werden.

**Revendications**

1. Appareil destiné à réaliser un essai de court-circuit instantané sur un générateur synchrone polyphasé, comprenant :

un commutateur (5) qui présente des premières bornes (5a, 5b, 5c) de connexion à des bornes de stator respectives (2a, 2b, 2c) d'un générateur électrique (2), et des secondes bornes (5d, 5e, 5f) connectées les unes aux autres ;

un module d'acquisition (18) configuré afin d'acquérir des signaux électriques ($V_R$', $V_S$', $V_T$') représentatifs des tensions de sortie ($V_R$, $V_S$, $V_T$) au niveau des bornes de stator respectives (2a, 2b, 2c) du générateur électrique (2) ; et un module de traitement (20) configuré afin de déterminer une tension d'essai ($V_{TEST}$) à partir des tensions de sortie ($V_R$, $V_S$, $V_T$) du générateur électrique (2) ;

**caractérisé en ce que** le module de traitement (20) est configuré afin de déterminer une fréquence actuelle ($f_c$) de la tension d'essai ($V_{TEST}$), et de comparer la fréquence actuelle ($f_c$) à une fréquence de référence ($f_{REF}$), où le module de traitement (20) est configuré en outre afin de maintenir le commutateur (5) ouvert lorsque la fréquence actuelle ($f_c$) est supérieure à la fréquence de référence ($f_{REF}$), et de fermer le commutateur (5) lorsque la fréquence actuelle ($f_c$) est sensiblement égale à la fréquence de référence ($f_{REF}$).

2. Appareil selon la revendication 1, où le module de traitement (20) est configuré afin de déterminer les passages par zéro de la tension d'essai ($V_{TEST}$), et de synchroniser la fermeture du commutateur (5) avec une crête de la tension d'essai ($V_{TEST}$).

3. Appareil selon l'une quelconque des revendications précédentes, comprenant un dispositif de commande (21), qui agit sur un actionneur (15) du commutateur (5) afin de fermer le commutateur (5) en réponse à un signal de commande ($S_c$) généré par le module de traitement (20).

4. Appareil selon l'une quelconque des revendications précédentes, comprenant un étage de mesure de courant (10) couplé aux secondes bornes (5d, 5e, 5f) du commutateur (5), et configuré afin de mesurer les courants de courts-circuits transitoires générés au niveau des bornes du stator (2a, 2b, 2c) du générateur électrique (2) en réponse à la fermeture du commutateur (5).

5. Appareil selon l'une quelconque des revendications précédentes, comprenant un générateur électrique (2) et un moteur principal (3) connecté au générateur électrique (2), destiné à faire tourner le rotor (4) du générateur électrique (2).

6. Procédé destiné à réaliser un essai de court-circuit instantané sur un générateur synchrone polyphasé, le procédé comprenant les étapes suivantes :

régler le rotor (4) d'un générateur électrique (2) à une vitesse de rotation actuelle ($\square_c$) supérieure à une vitesse de rotation de référence ($\square_{REF}$) ;
fournir des courants d'excitation ($I_E$) au rotor (4) du générateur électrique (2) pendant une décélération transitoire ;
acquérir des signaux électriques ($V_R$', $V_S$', $V_T$') représentatifs des tensions de sortie ($V_R$, $V_S$, $V_T$) au niveau des bornes de stator respectives (2a, 2b, 2c) du générateur électrique (2) ;
déterminer une tension d'essai ($V_{TEST}$) à partir des tensions de sortie ($V_R$, $V_S$, $V_T$) du générateur électrique (2) ;
provoquer un court-circuit entre les bornes du stator (2a, 2b, 2c) du générateur électrique (2), où l'étape consistant à provoquer un court-circuit comprend une étape consistant à fermer un commutateur (5) qui présente des premières bornes (5a, 5b, 5c) connectées aux bornes du stator respectives (2a, 2b, 2c) du générateur électrique (2), et des secondes bornes (5d, 5e, 5f) connectées les unes aux autres ;
**caractérisé par** les étapes suivantes :

déterminer la fréquence actuelle ($f_c$) de la tension d'essai ($V_{TEST}$), et comparer la fréquence actuelle ($f_c$) à une fréquence de référence ($f_{REF}$); et
provoquer le court-circuit lorsque la fréquence actuelle ($f_c$) est sensiblement égale à la fréquence de référence ($f_{REF}$).

7. Procédé selon la revendication 6, comprenant les étapes consistant à déterminer les passages par zéro de la tension d'essai ($V_{TEST}$), et à synchroniser la fermeture du commutateur (5) avec une crête de la tension d'essai ($V_{TEST}$).

8. Procédé selon la revendication 6 ou 7, comprenant une étape consistant à mesurer les courants de court-circuit transitoires générés au niveau des bornes du stator (2a, 2b, 2c) du générateur électrique (2), en réponse au court-circuit entre les bornes du stator (2a, 2b, 2c).

FIG. 1

FIG. 2

FIG. 3

EP 3 080 623 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Experimental Study on Sudden-short-circuit Characteristic of Synchronous Generator with SCFCL. **HIROYUKI HATTA et al.** IEEE TRANSACTIONS ON APPLIED SUPERCONDUCTIVITY. IEEE SERVICE CENTER, 01 March 2001, vol. 11, 2343-2346
- **LAURA L JUÁREZ-CALTZONTZIN et al.** Theoretical and Experimental Analysis of the Short Circuit Current Components in Salient Pole Synchronous Generators. *Proceedings of the 11th Spanish Portuguese Conference on Electrical Engineering (11CHLIE), Zaragoza,* 04 July 2009, 1-8, http://www.aedie.org/llchlie-papers/249-Juarez.pdf
- **ABDOLREZA ESMAELI.** A New Test Set to Synchronous Generator Sudden Three-phase Short-circuit Based on Power Electronic Technique and Microcontroller Technique. *Journal of Basic and Applied Scientific Research,* 01 January 2012, 8101-8105, http://www.textroad.com/pdf/JBASR/J. Basic. Appl. Sci. Res., 2(8)8101-8105, 2012.pdf
- Short Circuit Tests on a Coreless HTS Synchronous Generator. **BAILEY W O S et al.** IEEE TRANSACTIONS ON APPLIED SUPERCONDUCTIVITY. IEEE SERVICE CENTER, 01 June 2013, vol. 23, 5201505
- Parameter Estimation of a Synchronous-Generator Two-Axis Model Based on the Standstill Chirp Test. **CISNEROS-GONZA LEZ M et al.** IEEE TRANSACTIONS ON ENERGY CONVERSION. IEEE SERVICE CENTER, 01 March 2013, vol. 28, 44-51